Europäisches Patentamt

European Patent Office

Office européen des brevets

(19)

(11) Publication number: **0 289 963**
**A1**

# EUROPEAN PATENT APPLICATION

(12)

(21) Application number: **88106948.8**

(22) Date of filing: **29.04.88**

(51) Int. Cl.⁴: **C23C 16/48**

(30) Priority: **04.05.87 US 45290**

(43) Date of publication of application:
**09.11.88 Bulletin 88/45**

(84) Designated Contracting States:
**DE FR GB IT NL SE**

(71) Applicant: **GENERAL SIGNAL CORPORATION**
**PO Box 10010 High Ridge Park**
**Stamford Connecticut 06904(US)**

(72) Inventor: **Anderson, Roger W.**
**6035 Scotts Valey Drive**
**Scotts Valey California 95060(US)**
Inventor: **Roche, Gregory A.**
**4240 Erie Court**
**Santa Clara California 95054(US)**
Inventor: **Weber, Ann M.**
**557 Croyden Ct.**
**Sunnyvale California 94087(US)**

(74) Representative: **Baillie, Iain Cameron et al**
**c/o Ladas & Parry Isartorplatz 5**
**D-8000 München 2(DE)**

(54) **Apparatus for, and methods of, obtaining the movement of a substance to a substrate.**

(57) A beam of substantially coherent energy passes through an enclosure in a direction substantially parallel and contiguous to a substrate in the enclosure. A beam of non-coherent or substantially coherent energy is directed through the enclosure to the substrate in a direction transverse, but preferably perpendicular, to the substrate. Gases introduced into the enclosure combine to form a substance when subjected to the energy from the beams. This substance moves to the substrate and affects the substrate. For example, gaseous molecules such as silane ($SiH_4$) and nitrous oxide ($N_2O$) introduced into the enclosure in a direction substantially parallel and contiguous to the substrate combine to form silicon dioxide ($SiO_2$). The unreacted gases may be removed from the enclosure after flowing past the substrate. A small amount of a donor gas of a particular one of the elements such as oxygen may be introduced into the enclosure in gaseous form, preferably in a direction substantially parallel and contiguous to the substrate and in a range of 0.1% - 5.0% by volume of the total volume of the gases. The amount of the oxygen may be sufficiently small so that there is no significant thermal reaction with the silane. The beam of substantially coherent light may be pulsed at a rate dependent upon the rate of flow of the element such as oxygen into the enclosure. By introducing the small amount of this element (e.g., oxygen) into the enclosure and pulsing the beam of substantially coherent light, the deposition rate of the substance on the substrate may be enhanced by as much as 30-40% and the quality (i.e. as indicated by its index of refraction) of the substance deposited on the substrate may be enhanced.

FIG. 1

# APPARATUS FOR, AND METHODS OF, OBTAINING THE MOVEMENT OF A SUBSTANCE TO A SUBSTRATE

This invention relates to apparatus for, and methods of, producing a substantially uniform, pure and stable deposition of a substance at relatively low temperatures on a substrate. The invention particularly relates to apparatus for, and methods of, introducing a second donor gas of one of the elements in the substance to be deposited on the substrate, thereby obtaining a deposition of a substantially, uniform, pure and stable deposition of the substance on the substrate at a rate significantly faster than in the prior art. Although the invention relates primarily to the deposition of the substance on the substrate, the apparatus and methods constituting this invention can also be used to etch materials from the substrate.

Various types of apparatus and methods have been developed, and are presently in use, for depositing a substance such as silicon dioxide on a substrate such as a silicon wafer. Such apparatus and methods are disadvantageous in several respects. They require high temperatures in an enclosure holding the substrate in order to obtain the formation of the substance and the deposition of the substance on the substrate. Such high temperatures are undesirable because they produce warpage of the substrate and tend to produce uneven depositions on the substrate. Such high temperatures are also undesirable because they increase the difficulty of obtaining a substantially uniform, pure and stable deposition of the substance on the substrate. They also increase the tendency for the substance to become deposited in the enclosure at other places than on the substrate.

In recognition of the disadvantages discussed in the previous paragraph, apparatus and methods have been developed, and are in use, for depositing a substance on a substrate by techniques of chemical vapor deposition. Some of such apparatus and methods even provide for a deposition of the substance on the substrate at low temperatures. Such apparatus and methods are disadvantageous because they do not produce a substantially uniform, pure and stable deposition of the substance on the substrate.

In United States patent 4,581,248 issued to Gregory A. Roche for "Apparatus and Method for Laser-Induced Chemical Vapor Deposition", apparatus and methods are disclosed and claimed for producing a substantially uniform, pure and stable deposition of a substance on a substrate at low temperatures. In the apparatus and methods disclosed and claimed in United States patent 4,581,248 gases may be directed along a substrate, preferably in a direction substantially parallel and contiguous to the substrate, and may be removed from the substrate after flowing past the substrate. A beam of substantially coherent light is directed past the substrate in substantially parallel, and contiguous, relationship to the substrate to obtain the formation of the substance from the gases and the deposition of the substance on the substrate. Heat is focused and is directed on a localized basis to the substrate in a direction substantially perpendicular to the substrate to facilitate the deposition of the substance on the substrate.

This invention provides a number of improvements in the apparatus and methods disclosed and claimed in application Serial No. 587,284. Such improvements are designed to enhance the uniformity, purity and stability of a substance deposited on a substrate. Such improvements are further designed to enhance the rate at which the substance is deposited on the substrate. Furthermore, the quality (as indicated by the index of refraction) of the substance deposited on the substrate is enhanced. It will be appreciated, however, that the apparatus and methods of this invention may also be used to etch materials from a substrate.

In one embodiment of the invention, a beam of substantially coherent energy passes through an enclosure in a direction substantially parallel and contiguous to a substrate in the enclosure. A beam of non-coherent energy is directed through the enclosure to the substrate in a direction transverse, but preferably perpendicular, to the substrate.

Gases introduced into the enclosure react to form intermediates when subjected to the energy from the beams. These intermediates move to the substrate and affect the substrate. For example, gaseous elements such as silane ($SiH_4$) and nitrous oxide ($N_2O$) introduced into the enclosure in a direction substantially parallel and contiguous to the substrate react to form intermediates which in turn form silicon dioxide ($SiO_2$) at the substrate. The unreacted gases may be removed after flowing past the substrate.

An additional, or third molecule, such as oxygen, may be introduced into the enclosure in gaseous form, preferably in a direction substantially parallel and contiguous to the substrate. The oxygen may be introduced as a gas into the enclosure in a range of approximately 0.1% to five percent (5%) by volume of the gases in the enclosure. The volume of this additional gas is preferably sufficiently low so that there is insignificant thermal reaction with this additional gas under the conditions of the deposition.

The beam of substantially coherent light may be pulsed at a rate dependent upon the rate of flow of the element such as oxygen into the enclosure.

By introducing the molecules of the additional gas (e.g., oxygen) into the enclosure and pulsing the beam of substantially coherent light, the deposition rate of the substance on the substrate may be enhanced by more than thirty percent to forty percent (30%-40%) and the quality (as indicated by the index of refraction) of the substance deposited on the substrate may be enhanced.

In the drawings:

Figure 1 is a schematic elevational view of apparatus constituting one embodiment of the invention for obtaining a deposition of a substance on substrates in an enclosure;

Figure 2 is a perspective view of the apparatus shown in Figure 1 as seen from a position above and to one side of the apparatus;

Figure 3 is an enlarged fragmentary sectional view and is taken substantially on the line 3-3 of Figure 2;

Figure 4 is an enlarged fragmentary perspective view of certain of the members shown in Figure 2 and is partially broken away to show certain internal features in such members in some detail;

Figure 5 illustrates curves showing the time for obtaining chemical reactions to produce the substance, and the deposition of the substance on the substrates, by the apparatus and methods of this invention in comparison to apparatus and methods of the prior art; and

Figure 6 is an enlarged fragmentary perspective view of a modification of the embodiment shown in the previous Figures.

In one embodiment of the invention, a member generally indicated at 10 is provided for producing a beam of substantially coherent light, preferably in the ultraviolet range. The term "beam of substantially coherent light" is used advisedly since it may not be advantageous to have the light completely coherent. One reason is that completely coherent light may establish standing waves along the substrate and these standing waves may inhibit a uniform deposition of the substance on the substrate.

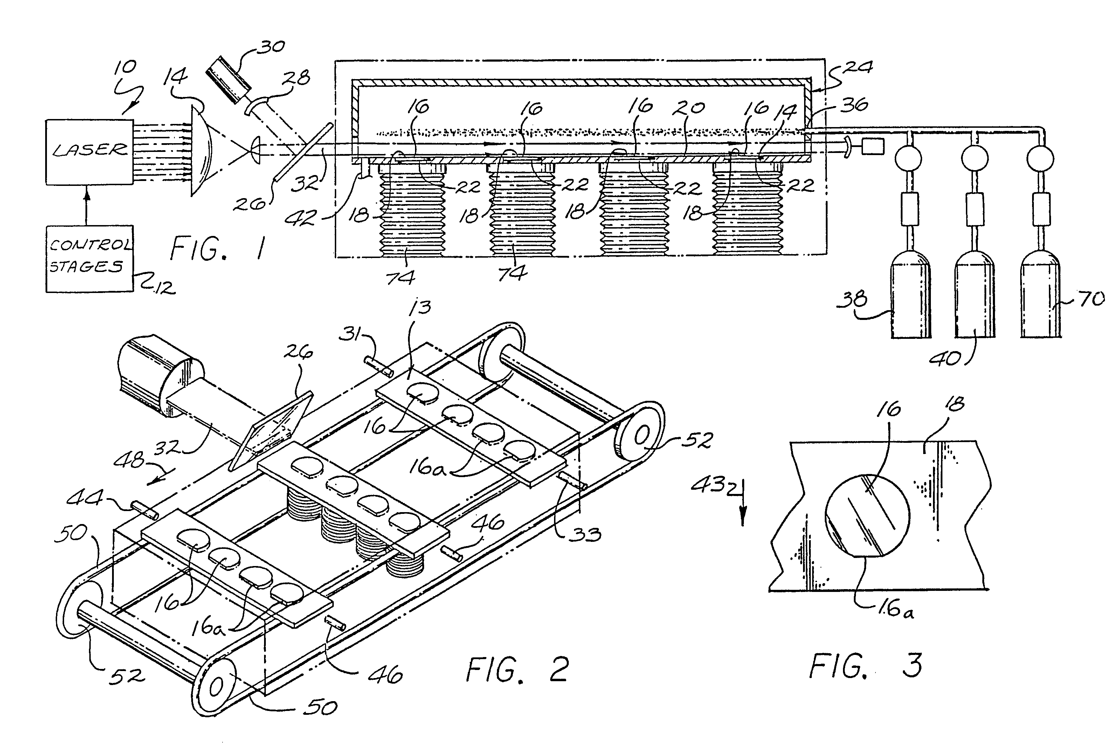

The member 10 may be a commercially available laser such as a Lumonics Hyperex 460 Excimer Laser. The laser beam may be pulsed at a suitable repetition rate such as one hundred hertz (100hz) but other repetition rates may also be used. The member 10 may be operated on the 193nm ArF line. This rate may be adjustable by control stages 12. The laser beam may be directed through a lens 14 toward substrates 16 such as integrated circuit wafers. Each of the substrates 16 may be provided with a flat periphery 16a (Figure 3) to facilitate a precise positioning of the substrate on a stepped shoulder 18 of a support plate 20. The stepped shoulder 18 defines the periphery of a window 22 in an enclosure 24.

The light from the laser 10 may be directed to a beam splitter 26 which transmits most of the light incident upon it and reflects a selected portion, which may be ten percent (10%) to fifteen percent (15%), to a photodetecter 28. The output of the phototdetector 28 is proportional to the power of the beam from the laser 10 and is introduced to a power meter 30 for monitoring the power output from the laser 10. The output from the meter 30 may be introduced to control stages (not shown) to maintain the magnitude of the energy beam from the laser 10 at a regulated value. This energy beam is indicated schematically at 32 in Figure 1.

Preferably the stepped shoulder 18 (Figure 1) is provided with a height corresponding substantially to the thickness of the substrate 16 so that the surface to be coated on the substrate 16 is substantially flush with the surface of the plate 20. In this way, the gases moving past the substrate 16 have a substantially uniform flow rather than being subjected to turbulence such as tends to occur when the surface of the substrate 16 is not substantially flush with the surface of the plate.

A nozzle 36 (Figure 1) is disposed in the enclosure 24, preferably in contiguous relationship to the substrate 16 at one end of the enclosure. The nozzle 36 may be disposed (Figure 1) at the far end of the enclosure 24 in the direction of passage of the light beam 32 through the enclosure. Alternatively, the nozzle 36 may be disposed at the near end of the enclosure in the direction of movement of the light beam 32 or nozzle 36 may be disposed in a direction transverse to the beam 32. Furthermore, the nozzle 36 is preferably disposed at substantially the same vertical level as the top surfaces of the substrates 16 in the enclosure 24 and is adapted to introduce the gases under pressure into a direction substantially parallel to the substrates. Preferably the total pressure of the donor gases introduced into the enclosure 24 through the nozzle 36 is in the range of approximately two (2) to six (6) torr.

The nozzle 36 is adapted to introduce a mixture of gases which react to form intermediates when energized at a relatively high energy level such as by the light beam 32. For example, when the substance is silicon dioxide, the gases may be a silicon donor such as silane ($SiH_4$) in nitrogen and an oxygen donor such as nitrous oxide ($N_2O$). The gas such as silane in nitrogen may be obtained from a source 38 (Figure 1) and the gas such as nitrous oxide may be obtained from a source 40.

An orifice 42 (Figure 1) is also disposed in the enclosure 24 for the evacuation of unreacted gases. Preferably the orifice 42 is disposed in the enclosure 24 in contiguous relationship to the substrates 16 at a second end of the enclosure 24 opposite the nozzle 36. The orifice 42 is preferably disposed at substantially the same vertical level as the top surfaces of the substrates 16 in the enclosure 24 (although it is not shown in this position in Figure 1).

By providing the nozzle 36 and the orifice 42 at opposite ends of the enclosure 24 and in contiguous relationship to the substrates 16, an efficient flow of gas is obtained along the substrates for energizing by the light beam 32. Such an arrangement of the nozzle 36 and the orifice 42 is also advantageous in that the gas flows tend to be localized such that the intermediates formed from the donor gases and the substance formed from the intermediates tend to be formed at the substrates 16 and to be deposited substantially only on the substrates. This maximizes the deposition of the substance on the substrates 16. It also minimizes any tendency for the substance to be deposited on other members. As will be appreciated, the deposition of the substance on such other members may interfere with the efficient operation of the apparatus constituting this invention.

Although the nozzle 36 and the orifice 42 in Figure 1 are displaced from each other in the direction of the light beam 32, it will be appreciated that members corresponding to the nozzle and the orifice may be disposed in a direction transverse to that shown in Figure 1. For example, inlet nozzles 44 (Figure 2) may be disposed at one lateral end of the enclosure 18 and outlet nozzles 46 (Figure 2) may be disposed at the opposite lateral end of the enclosure.

When the beam 32 of substantially coherent light is directed through the enclosure 24 toward the substrates 16, it energizes molecules of the donor gases introduced to the vicinity of the substrates through the nozzle 36. This causes the donor gases to form reactive intermediates of the substance (such as silicon dioxide) near the substrates 16. The intermediates then react at a position near the substrates 16 to form the substance and the substance becomes deposited on the substrates. As will be seen, the deposition of the substance on the substrates 16 is facilitated by the formation of the reactive intermediates in contiguous relationship to the substrates.

The substrates 16 may be moved relative to the light beam 28. For example, the substrates 12 may be moved relative to the light beam 28 in a direction indicated by an arrow 48 (Figure 2), particularly when the light beam 32 is not as wide as the substrate. This may be accomplished by belts 50 and pulleys 52. As will be seen, this direction is perpendicular to the direction in which the light beam 32 moves along the substrates 16. The movement of the substrates 16 relative to the light beam 28 facilitates the deposition of the substance uniformly on the substrates.

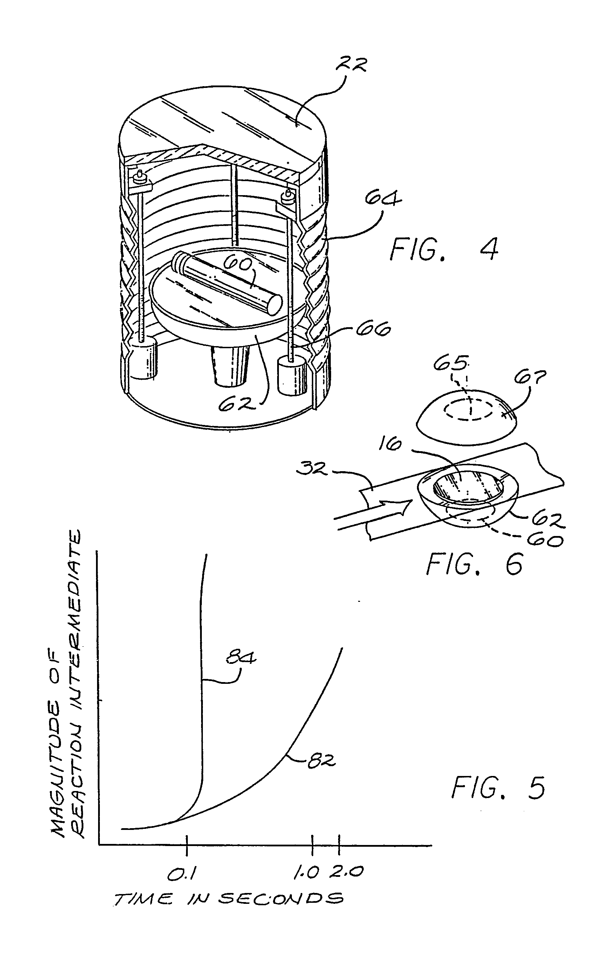

The deposition of the substance on the substrate 12 may be facilitated by applying heat on a localized basis to the substrates. The heat may be produced by a lamp 60 (Figure 4) and may be converted into a beam by a reflector 62 such as a parabolic reflector. The reflector 62 directs the heat beam through the windows 22 to the substrates 16 on a localized basis so that the heat is focused on the substrates without being directed to any other member or element in the enclosure 24.

By directing the heat beam substantially only to the substrates 16, the deposition of the substance is limited substantially only to the substrates 16 and the deposition of the substance on other members in the enclosure 24 is minimized. The focusing of the heat on each substrate 16 may be enhanced by disposing the window 22 on a bellows 64 which is adjustable in height as by any suitable arrangement 66 such as a ball screw. The construction and operation of the lamp 60, the reflector 62 and the bellows 64 are fully disclosed in United States patent 4,581,248.

In addition to the disposition of the lamp 60 and the reflector 62 below the window 22 as shown in Figure 4, a lamp 65 and a reflector 67 may be disposed above the window as shown in Figure 6. The light from the ultraviolet lamp 65 may be preferably in the ultraviolet range and may be focussed by the reflector 67. The focussed light may be directed to the substrate on the window 22. The lamp 65 may provide coherent or incoherent light and such light may be pulsed or continuous wave.

The apparatus and methods described above have certain important advantages. They produce a deposition of the substance such as silicon dioxide on the substrates 16 at relatively high rates such as rates in the order of three thousand angstroms per minute (3000 A/min.) Such deposition rates are substantially independent of the substrate temperature.

The apparatus and methods described above are also advantageous in that they produce the deposition of the substance on the substrates 16 at relatively low substrate temperatures. Furthermore, the temperature of the substrates 16 can be precisely controlled by the apparatus and methods of this invention. For example, at substrate temperatures below approximately 200° C., the oxide films deposited on the substrates 16 have been found to be milky in appearance and relatively easily scratched. At substrate temperatures above approximately 200° C. and below about 400° C., the oxide films deposited on the substrates 16 have been found to be substantially transparent and uniform. Furthermore, when the temperature of the substrates 16 is above approximately 250° C., the oxide films deposited on the substates 16 have been found to be quite scratch-resistant and adherent.

The apparatus and methods described above facilitate the deposition of the substance on the substrates 16 at high rates to obtain a high purity, uniformity and stability of the substance on the substrates. For example, the passage of the donor gases close to the surface of the substrates 16 facilitates the deposition of the substance on the substrates at a relatively high rate and with properties of high uniformity, purity and stability.

The formation of the substance such as silicon dioxide may be obtained by subjecting nitrous oxide and silane to the light beam 28 to produce the following chemical reaction:

$$SiH_4 + N_2O + light \rightarrow SiO_2 + other products. \quad (1)$$

The light may have a wavelength of aproximately one hundred and ninety three nanometers (193 nm). The formation of silicon dioxide may also be provided by the following chemical reaction:

$$SiH_4 + O_2 + light \rightarrow SiO_2 + other products.$$

In this reaction, no light has to be provided. Silicon dioxide ($SiO_2$) may also be formed as follows from a third reaction:

$$SiH_4 + N_2O + O_2 + light \rightarrow SiO_2 + other products$$

The light in this reaction may have a wavelength of approximately one hundred and ninety three nanometers (193 nm).

The formation of silicon dioxide by the apparatus and methods described above is only illustrative. A number of other substances may also be formed by such apparatus and methods without departing from the scope of the invention. These include silicon nitride ($Si_3N_4$), alumina ($Al_2O_3$) and zinc oxide ($ZnO$). These substances may be produced from chemical reactions such as those specified below:

$$SiH_4 + NH_3 \rightarrow Si_3N_4 + other products \quad (4)$$

$$Al(CH_3)_3 + N_2O \rightarrow Al_2O_3 + other products \quad (5)$$

$$Zn(CH_3) + NO_2 \rightarrow ZnO + other products \quad (6)$$

The embodiment constituting this invention also includes a source 70 for introducing an additional gas into the enclosure 24 through the nozzle 36. Preferably this additional gas is introduced into the enclosure 24 at a position contiguous to the substrates 16 and in a direction substantially parallel to the substrates. This additional gas is exhausted through the orifice 42 after it has flowed past the substrates 16.

The additional gas is preferably an additional donor gas providing one of the elements which forms the substance deposited on the substrates 16. For example, when the substance deposited on the substrates 16 is silicon dioxide, the additional gas may provide oxygen. Similarly, when the substance to be deposited on the substrates 16 is silicon nitride, the additional gas provide nitrogen such as by a compound containing nitrogen.

The additional gas preferably is introduced into the enclosure 24 in a relatively low percentage by weight when compared to the amount of the other gases introduced into the enclosure. For example, when silane ($SiH_4$) and nitrous oxide are introduced into the enclosure 24 to form silicon dioxide for deposition on the substrates 16, the amount of oxygen introduced to the enclosure 24 from source 70 may be in the order of approximately two percent (2%) to five percent (5%) by volume of the gases in the enclosure.

Under certain conditions, the amount of oxygen introduced to the enclosure 24 from source 70 may be greater than five percent (5%) by volume. Under these circumstances, the rate of the thermal reaction as specified above in equation (2) is preferably insignificant in comparison to the rate of the photolytic reaction as set forth in equation (1) or equation (3).

When a small amount of gas such as oxygen is introduced into the enclosure 24, certain advantages result in addition to those described above. One advantage is that the rate of deposition of the substance on the substrate is significantly enhanced. When the additional gas constitutes oxygen, the rate of deposition of the silicon dioxide on the substrates 16 may be enhanced by more than thirty percent (30%) to forty percent (40%) in comparison to the rate of deposition of the silicon dioxide without the addition of such additional gas.

Other significant advantages result when a small amount of an additional donor gas such as oxygen is introduced into the enclosure 24. For example, the silicon dioxide is deposited on the substrates 16 with an index of refraction of substantially 1.46. This constitutes an optimal index of refraction. Furthermore, the index of refraction of the silicon dioxide tends to be substantially constant at every position on the substrate and throughout the thickness of the substrate.

Without the introduction of the additional donor gas such as oxygen into the enclosure 24, the index of refraction of the silicon dioxide deposited on the substrates 16 is approximately 1.50. Furthermore, the index of refraction of the silicon dioxide does not tend to be constant at different thicknesses of the silicon dioxide on the substrates 16.

When an additional donor gas such as oxygen is introduced into the enclosure 24, the substance deposited on the substrates 16 tends to be quite dense. This may result in part from the fact that the reaction of the donor gases to form reactive intermediates of the substance such as silicon dioxide tends to occur quite close to the surface of the substrates. Furthermore, as will be seen from the subsequent discussion, the gaseous molecules of the intermediates reacting to form the substance such as silicon dioxide are not hot when such a reaction occurs. This causes the reactive intermediates to impinge on the upper surfaces of the substrates 16 in Figure 1 without reacting to form silicon dioxide in the gas phase. This tends to enhance the surface phase reaction of the gases at the surface of the substrate instead of the gas phase reaction above the surface of the substrate. This is advantageous because it improves the integrity of the deposition as well as the conformality of the deposition. "Conformality" may be defined as the uniformity of coverage by the deposition of a three (3)-dimensional structure.

The advantages discussed in the previous paragraph occur in part because the light beam 32 is in a direction substantially parallel to the substrates 16 and is at a position close to the surfaces of the substrates. Actually, the position of the light beam 16 is considerably closer to the surfaces of the substrates than in any techniques of the prior art. This causes the reactive intermediates to be formed significantly closer to the surfaces of the substrates 16 than the reactive intermediates formed by the techniques of the prior art.

The temperature of the donor gases is also lower by the use of the light beam 32 than by the techniques of the prior art. Because of the relatively low temperatures of the reactive intermediates, the reactive intermediates have an increased chance of migrating to the surfaces of the substrates 16 before reacting to form the deposition substance than in the techniques of the prior art. Actually, some of this reaction of the reaction intermediates to form the deposition substance even occurs on the surfaces of the substrates 16. This allows the growing deposition on the surfaces of the substrates 16 to "spread itself" more uniformly across such surfaces. This is especially noticeable in three (3)-dimensional structures. This increase in uniformity corresponds to an increasing conformality.

The effects discussed in the previous two (2) paragraphs are advantageous because the allow the deposition substance such as silicon dioxide to be formed more favorably and with greater integrity than if they were formed at elevated temperatures in the gaseous phase. This is because the molecules sometimes aggragate into crystalline shapes when formed at elevated temperatures in the gaseous phase. These crystalline shapes produce defects when they are incorporated into the deposition growing on the surfaces of the substrates 16. The aggregation becomes aggravated as the distance between the formation of the deposition molecules (such as silicon dioxide) and the surfaces of the substrates 16 increases. This aggregation has been designated as "gas phase nucletion".

Silane ($SiH_4$) and oxygen have been introduced as donor gases into the enclosure 24 at conditions where the total pressure of the donor gases is in the range of approximately two (2) to six (6) torr, the pressure of the silane is approximately 0.076 torr and the pressure of the oxygen is approximately 0.051 torr. The temperature in the enclosure has been in the range of 200° C. to 400° C. and the residence time of the gases in the gases in the enclosure has been less than one tenth of a second (0.1 second). Without the laser, negligible deposition of silicon dioxide on the substrates 16 occurs under such circumstances.

A thermally activated chemical reaction between silane and oxygen can be made to occur at relatively low temperatures under some sets of parameters. However, these parameters are difficult to control to obtain a good coating of silicon dioxide on the surfaces of the substrates 16. Furthermore, the silicon dioxide is not deposited at a constant rate on the surfaces of the substrates 16. This results in part from the complicated chemical kinetics which occur in the production from the donor gases of the intermediates which then react to produce the silicon dioxide. Because of such complicated chemical kinetics, the rate of production of the reaction intermediates is initially slow after the donor gases are mixed in the enclosure 24. When the concentration of reaction intermediates has increased sufficiently, the rate of formation of silicon dioxide increases. The initial period for the formation of the reaction intermediates is dependent upon the temperature and concentrations of the donor gases and can vary from a small fraction of a second to minutes.

The reactions of silane with nitrous oxide to produce silicon dioxide or of silane with ammonia to produce silicon nitride are also not optimal. At reduced temperatures, the reactions of the donor gases proceed slowly at relatively low temperatures because there is insufficient thermal energy to break chemical bonds of the donor gases efficiently. The chemical reactions can be provided the impetus to yield satisfactory rates of deposition but these chemical depositions occur at undesirably high temperatures. As previously stated, these temperatures are undesirably high because they tend to produce warpage of the substrates and uneven depositions on the substrates. They also increase the difficulty of obtaining a substantially uniform, pure and stable deposition of the substance on the substrate.

In one practice of this invention, the following parameters have been provided:

Total pressure 3 torr
Pressure of silane ($SiH_4$) 0.076 torr
Pressure of oxygen ($O_2$) 0.051 torr
Pressure of nitrous oxide ($N_2O$) 0.763 torr
Temperature of enclosure 24 300°C.

When such parameters are provided, the nitrous oxide ($N_2O$) becomes disassociated with ultraviolet radiation to produce oxygen (0) atoms. The oxygen atoms react with silane to product intermediates which in turn react to cause the reaction between silane and oxygen to progress.

With the parameters specified above, approximately two (2) photons have to be provided to deposit a molecule of silicon dioxide. The number of photons required to be provided to deposit each molecule of silicon dioxide on the substrates 16 decreases with increases in the pressure of the oxygen molecules ($O_2$). By including the nitrous oxide in the mixture, the reaction between silane and oxygen is photochemically enhanced. Such a reaction uses the photons considerably better to obtain the production of silicon dioxide than the reaction initiated between silane and nitrous oxide without additional amounts of oxygen being present. (This reaction requires approximately four (4) photons for one (1) molecule of $SiO_2$).

The light from the lamp 60 and the reflector 62 may also be used to enhance the deposition reactions on the surfaces of the substrates. Such light may be either coherent or non-coherent and may be pulsed or continous wave (cw). When absorbed by the surfaces of the substrates 60, such light can improve by photolytic or thermal processes the density of the silicon dioxide coating deposited on the surfaces of the substrates 16. Such light may photochemically evolve hydrogen molecules ($H_2$) or other undersirable elements from the surfaces of the substrates 16 or may anneal such surfaces as by heating. Such light may also tend to clean such surfaces for deposition reactions and heat such surfaces to enhance the facility and uniformity of the reactions of such surface with the silicon dioxide produced in gaseous form at positions contiguous to such surfaces. Such light may also participate directly in the photochemical reactions which produce the intermediates.

As a result of the introduction of the additional gas such as oxygen into the enclosure 24, the substance such as silicon dioxide deposited on the surfaces of the substrates 16 may be provided with stoichiometric properties. Specifically, the properties of the substance deposited on the surfaces of the substrates 16 may be varied by varying the amount of the additional donor gas introduced into the enclosure 24. For example, the substance may have an index of refraction of approximately 1.50 when no oxygen is introduced into the enclosure; the substance may have an index of refraction of substantially 1.46 when an additional amount of oxygen of approximately two percent (2%) to five percent (5%) by volume is introduced into the enclosure 24.

The laser beam 32 is preferably pulsed at a rate dependent upon the rate of flow of the additional donor gas such as oxygen into the enclosure 24. The rate of pulsing the laser beam 32 may be varied in a conventional manner. Preferably the laser beam 32 is pulsed at a rate which allows a fresh supply of the additional donor gas such as oxygen and the gases from the nozzle 36 to appear above the substrates 16 every time that the laser beam is pulsed. However, since it is generally desired to produce the deposition of the substance on the substrates 16 at as high a rate as possible, the laser beam 32 is preferably pulsed immediately after a fresh supply of the donor gas such as oxygen and the other donor gases has been introduced into the space above all of the substrates in Figure 1.

In one embodiment of the invention, the enclosure 24 was provided with a temperature of approximately 300°C. and a pressure of approximately three (3) Torr. The laser beam 32 was provided with a wavelength of approximately one hundred and ninety three nanometers(193nm) and the radiation from the lamp 60 was provided with a wavelength of approximately two hundred and forty nine nanometers (249nm) or two hundred and fifty four nanometers (254nm). The rate of flow of silane into the enclosure 24 was approximately fifteen cubic centimeters per minute (15cc/min.) and the rate of flow of nitrous oxide into the enclosure 24 was approximately one hundred and fifty cubic centimeters per minute (150 cc/min.). The additional gas such as oxygen was regulated to flow into the enclosure 24 at a rate of approximately ten (10) cubic centimeters per minute (10cc/min.). The silane was introduced into the enclosure with a pressure of approximately 0.076 torr, the oxygen with a pressure of approximately 0.051 torr and the nitrous oxide with a pressure of approximately 0.763 torr.

Although this invention has been disclosed and illustrated with reference to particular embodiments, the principles involved are susceptible for use in numerous other embodiments which will be apparent to persons skilled in the art. The invention is, therefore, to be limited only as indicated by the scope of the appended claims.

## Claims

1. A method of obtaining a movement of a substance to a substrate in an enclosure including the steps of directing a beam of substantially coherent energy through the enclosure in a direction substantially parallel and contiguous to the substrate, directing additional energy through the enclosure in a direction transverse to said beam, and providing first and second donor gases having properties of reacting in the presence of the coherent and additional energy to form the substance and to provide for the movement of the substance to the substrate, characterized by introducing into the enclosure an additional donor gas to enhance the formation of the substance and the movement of the substance to the substrate.

2. A method according to claim 1, characterized in that the introduction of the additional donor gas into the enclosure is in a direction substantially parallel and contiguous to the substrate, the first and second donor gases respectively providing first and second elements and the additional donor gas providing an additional amount of a particular one of the first and second elements.

3. A method according to claim 2, characterized in that the particular one of the first and second elements is selected from the group including oxygen and nitrogen.

4. A method according to any of claims 1 to 3, characterized in that the amount of the additional donor gas introduced into the enclosure is in the range of approximately 0.1 percent to five percent of the donor gases in the enclosure by volume.

5. A method according to any of claims 1 to 4, characterized in that the beam of substantially coherent energy is pulsed at a rate dependent upon the rate of flow of the additional donor gas into the enclosure and in that the additional energy is non-coherent.

6. A method according to any of claims 1 to 5, characterized in that the characteristics of the beam are controlled in accordance with the rate of flow of the additional donor.

7. A method according to any of claims 1 to 6, characterized in that the first and second donor gases are introduced in a direction substantially parallel to the substrate within the enclosure, said gases being introduced at one end of the enclosure and exhausted at the other end.

8. Apparatus for obtaining a movement of a substance to a substrate, said apparatus including an enclosure (24), a support (20) for supporting the substrate for disposition in a flat relationship, a source (10) for providing and directing a beam (32) of substantially coherent light in a first direction substantially parallel, and contiguous, to the substrate, a supply for providing donor gases having characteristics of reacting to produce intermediate which in turn react to form the substance when subjected to a particular energy level, a nozzle (36) for introducing the donor gases to a position contiguous to the substrate at a first end of the substrate for passage along the substrate and for reaction to form the intermediates in accordance with the direction of the light beam to the substrate, an exhaust (42) disposed in contiguous relationship to the substrate at a second end of the substrate opposite the first end for exhausting the unreacted donor gases, and means for directing energy to the substrate in a second direction opposite to the first direction to facilitate the formation of the substance from the donor gases, characterized in that a source (70, 36) is provided for introducing, to a position near the substrate, an additional donor gas to facilitate the formation of the substance.

9. Apparatus according to claim 8, characterized in that the source (70, 36) for introducing the additional donor gas to the substrate is disposed and formed to direct the additional donor gas in a direction substantially parallel, and contiguous, to the substrate.

FIG. 1

FIG. 2

FIG. 3

0 289 963

22

64

FIG. 4

60

66

62

65

67

16

32

62

60

FIG. 6

MAGNITUDE OF REACTION INTERMEDIATE

84

82

0.1

1.0 2.0

TIME IN SECONDS

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | EP-A-0 208 966 (ROCHE)<br>* Figure 1; claim 1 * | 1,7 | C 23 C 16/48 |
| Y | EP-A-0 178 200 (FAIRCHILD CAMERA & INSTRUMENT CORP.)<br>* Claim 1 * | 1,7 | |
| A | * Claims 2,3,4,7 * | 2 | |
| A | PATENT ABSTRACTS OF JAPAN, vol. 1, no. 112, 28th September 1977, page 4074 E 77; & JP-A-52 44 166 (HITACHI SEISAKUSHO K.K.) 06-04-1977<br>* Abstract * | 1,2,7,9 | |
| A | US-A-4 631 199 (J.T. HALL)<br>* Claims 1-4; page 6, lines 34-48 * | 1,2,3,4,7,9 | |
| A | PATENT ABSTRACTS OF JAPAN, vol. 8, no. 115 (E-247)[1552], 29th May 1984; & JP-A-59 28 345 (NIPPON DENKI K.K.) 15-02-1984<br>* Abstract * | 1 | TECHNICAL FIELDS SEARCHED (Int. Cl.4) |
| A | DE-A-2 144 362 (PHILIPS PATENTVERWALTUNG)<br>* Claims 1,2,6,7,8,9 * | 1,2,3 | C 23 C<br>C 30 B |
| A | PATENT ABSTRACTS OF JAPAN, vol. 9, no. 5 (C-260)[1728], 10th January 1985; & JP-A-59 159 980 (MATSUSHITA DENKI SANGYO K.K.) 10-09-1984<br>* Abstract * | 1,8,9 | |

-/-

The present search report has been drawn up for all claims

| Place of search | Date of completion of the search | Examiner |
|---|---|---|
| THE HAGUE | 04-08-1988 | ELSEN D.B.A. |

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN, vol. 8, no. 178 (C-238)[1615], 16th August 1984; & JP-A-59 73 496 (MATSUSHITA DENKI SANGYO K.K.) 25-04-1984 <br> * Abstract * | 8 | |
| A | APPLIED PHYSICS A. SOLIDS AND SURFACES, vol. A-38, no. 3, November 1985, pages 221-226, Springer-Verlag, Berlin, DE; A. TATE et al.: "Theoretical and experimental investigations on the deposition rate and processes of parallel incident laser-induced CVD" | | |
| A | PATENT ABSTRACTS OF JAPAN, vol. 8, no. 150 (C-233)[1587], 12th July 1984; & JP-A-59 53 674 (SUWA SEIKOSHA K.K.) 28-03-1984 | | |
| A | EP-A-0 030 798 (HUGHES AIRCRAFT CO.) | | |

TECHNICAL FIELDS SEARCHED (Int. Cl.4)

The present search report has been drawn up for all claims

| Place of search | Date of completion of the search | Examiner |
|---|---|---|
| THE HAGUE | 04-08-1988 | ELSEN D.B.A. |